# EUROPEAN PATENT APPLICATION

(11) **EP 4 672 343 A1**
(43) Date of publication of application: **31.12.2025**
(21) Application number: 23937338.4
(22) Date of filing: 26.12.2023
(51) Int. Cl.: H01L 31/055, H01L 31/0747, H01L 31/18

(54) **SOLAR CELL AND PREPARATION METHOD THEREFOR**

(30) Priority: 17.05.2023 CN 202310571410
(71) Applicant: Risen Energy Co. Ltd, Ningbo Zhejiang 315600 (CN)
(72) Inventor: HU, Yuting, Ningbo, Zhejiang 315600 (CN); RAZZAQ, Shehroz, Ningbo, Zhejiang 315600 (CN); LIU, Lin, Ningbo, Zhejiang 315600 (CN); REN, Mingchong, Ningbo, Zhejiang 315600 (CN); YANG, Bochuan, Ningbo, Zhejiang 315600 (CN)
(74) Representative: Berggren Oy
(86) International application number: PCT/CN2023/142069
(87) International publication number: WO 2024/234667

(57) **Abstract**

Embodiments of the present invention relate to the field of solar cells, and disclose a solar cell and a preparation method therefor. The solar cell comprises a crystalline silicon layer. A first intrinsic layer, a first doped layer, a first transparent conductive film layer, and a first metal electrode are sequentially stacked on the front surface of the crystalline silicon layer from inside to outside. A second intrinsic layer, a second doped layer, a second transparent conductive film layer, and a second metal electrode are sequentially stacked on the back surface of the crystalline silicon layer from inside to outside. A light conversion layer is disposed on the front surface and/or back surface of the first transparent conductive film layer and/or the second transparent conductive film layer. The light conversion layer contains an yttrium aluminum garnet-based quantum dot material. The solar cell of the embodiments of the present invention can effectively convert UV light into visible light. The utilization rate of the spectrum is remarkably increased, and the damage of UV light to a battery is reduced, thus the conversion efficiency and reliability of the battery are increased.

## Description

### CROSS-REFERENCE TO RELATED APPLICATION

The present invention claims the priority to the Chinese patent application with the filling No. 2023105714100 filed with the Chinese Patent Office on May 17, 2023, and entitled "SOLAR CELL AND PREPARATION METHOD THEREFOR", the contents of which are incorporated herein by reference in entirety.

### TECHNICAL FIELD

The present invention relates to the field of solar cells, and in particular, to a solar cell and a preparation method therefor.

### BACKGROUND ART

In recent years, silicon solar cells have been one of large-scale commercialized photoelectric conversion devices, in which heterojunction solar cells (Heterojunction with Intrinsic Thin-layer, HIT), as a photovoltaic industry technology with good application prospects, have attracted widespread attention. However, the conversion efficiency of heterojunction solar cells has gradually reached a limit. In order to further improve the output power of photovoltaic cells and modules, light conversion technology has become an effective method. The so-called light conversion technology is to convert light that cannot be utilized by a cell into light that can be utilized by the cell.

### SUMMARY

The present invention provides a solar cell. The solar cell comprises a crystalline silicon layer. A first intrinsic layer, a first doped layer, a first transparent conductive film layer, and a first metal electrode are sequentially stacked from inside to outside on a front side of the crystalline silicon layer. A second intrinsic layer, a second doped layer, a second transparent conductive film layer, and a second metal electrode are sequentially stacked from inside to outside on a back side of the crystalline silicon layer. Light conversion layer(s) are further provided in the solar cell, and a light conversion layer is located in at least one of following areas: an area on the first transparent conductive film layer where the first metal electrode is not disposed, an area on the second transparent conductive film layer where the second metal electrode is not disposed, an area between the first doped layer and the first transparent conductive film layer, and an area between the second doped layer and the second transparent conductive film layer. The light conversion layer contains an yttrium aluminum garnet-based quantum dot material.

Optionally, one or two light conversion layers are provided.

Optionally, two light conversion layers are provided, and are disposed respectively on the front side and the back side of the crystalline silicon layer.

Optionally, the light conversion layer comprises light conversion particles, and the light conversion particles comprise the yttrium aluminum garnet-based quantum dot material.

Optionally, a surface of the crystalline silicon layer is a pyramid textured surface, and a thickness of the light conversion layer is in a range of 1/50 to 1/2 of a width of the pyramid textured surface.

Optionally, the width of the pyramid textured surface is in a range of 300 nm to 5 µm, and the thickness of the light conversion layer is in a range of 6 nm to 2.5 µm.

Optionally, the yttrium aluminum garnet-based quantum dot material comprises at least one selected from YAG:Ce³⁺, YAG:Pr³⁺, and YAG:Cr³⁺.

Optionally, a size of the yttrium aluminum garnet-based quantum dot material is in a range of 5 nm to 2 µm.

Optionally, the size of the yttrium aluminum garnet-based quantum dot material is in a range of 2 nm to 100 nm, optionally, in a range of 2 nm to 50 nm, optionally, in a range of 2 nm to 20 nm.

Optionally, the light conversion layer further comprises other light conversion particles.

Optionally, the other light conversion particles are selected from nitride series quantum dot materials, silicate series quantum dot materials, or fluoride series quantum dot materials.

Optionally, a content of the other light conversion particles in the light conversion particles does not exceed 10 wt%.

Optionally, a content of the yttrium aluminum garnet-based quantum dot material in the light conversion layer is in a range of 40 wt% to 60 wt%.

Optionally, the light conversion layer further contains a polymer matrix, and the light conversion particles are dispersed in the polymer matrix.

Optionally, the light conversion layer further contains the polymer matrix, and the yttrium aluminum garnet-based quantum dot material is dispersed in the polymer matrix.

Optionally, the polymer matrix is prepared from a polymer material and an organic solvent.

The present invention provides a preparation method of the foregoing solar cell, comprising following steps:

forming the first intrinsic layer, the first doped layer, and the first transparent conductive film layer that are sequentially stacked on the front side of the crystalline silicon layer; forming the first metal electrode on a front side of the first transparent conductive film layer; forming the second intrinsic layer, the second doped layer, the second transparent conductive film layer, and the second metal electrode that are sequentially stacked on the back side of the crystalline silicon layer; and providing the light conversion layer(s) in at least one of the following areas: the area on the first transparent conductive film layer where the first metal electrode is not disposed, the area on the second transparent conductive film layer where the second metal electrode is not disposed, the area between the first doped layer and the first transparent conductive film layer, and the area between the second doped layer and the second transparent conductive film layer.

Optionally, the light conversion layer is formed by printing and curing a light conversion paste.

Optionally, the light conversion paste comprises light conversion particles, a polymer material, and an organic solvent.

Optionally, the light conversion particles contain the yttrium aluminum garnet-based quantum dot material.

Optionally, the light conversion layer is formed by printing and curing a light conversion paste, and the light conversion paste comprises the yttrium aluminum garnet-based quantum dot material, a polymer additive, and an organic solvent.

Optionally, a mass ratio of the light conversion particles, the polymer additive, and the organic solvent in the light conversion paste is (0.01-0.7): (0.01-0.7): 1.

Optionally, the light conversion particles contain the yttrium aluminum garnet-based quantum dot material.

Optionally, the mass ratio of the yttrium aluminum garnet-based quantum dot material, the polymer additive, and the organic solvent in the light conversion paste is (0.01-0.7): (0.01-0.7): 1.

The present invention provides a solar cell comprising a light conversion layer. The light conversion layer contains light conversion particles, and the light conversion particles comprise an yttrium aluminum garnet-based quantum dot material.

Optionally, in the light conversion layer, a content of the yttrium aluminum garnet-based quantum dot material is in a range of 40 wt% to 60 wt%.

### BRIEF DESCRIPTION OF DRAWINGS

To illustrate the technical solutions of the embodiments of the present invention more clearly, the drawings that need to be used in the embodiments of the present invention will be briefly introduced below.
FIG. 1 is a schematic structural diagram of a solar cell provided in an embodiment of the present invention;
FIG. 2 is a schematic structural diagram of a surface of a crystalline silicon layer in FIG. 1;
FIG. 3 is a schematic diagram showing a method for forming a light conversion layer in FIG. 1;
FIG. 4 is a schematic structural diagram of a solar cell provided in another embodiment of the present invention;
FIG. 5 is a schematic structural diagram of a solar cell provided in another embodiment of the present invention;
FIG. 6 shows a light conversion curve of a light conversion layer in a solar cell of Example 1;
FIG. 7 shows spectral response curves of a solar cell of Example 1 and a conventional cell (with UV cut-off); and
FIG. 8 shows internal quantum efficiency curves of a solar cell of Example 1 and a conventional cell (with UV cut-off).

Reference numerals: 110-crystalline silicon layer; 120-first intrinsic layer; 130-first doped layer; 140-first transparent conductive film layer; 150-first metal electrode; 160-second intrinsic layer; 170-second doped layer; 180-second transparent conductive film layer; 190-second metal electrode; 210-first light conversion layer; 220-second light conversion layer; 230-third light conversion layer; 240-fourth light conversion layer; 2-light conversion paste; 3-screen; 4-scraper; 5-metal paste; 10-cell to be printed; 11-non-electrode area; 12-electrode area.

### DETAILED DESCRIPTION OF EMBODIMENTS

The technical solutions in the embodiments of the present invention will be described below with reference to the drawings in the embodiments of the present invention.

In order to make the objectives, technical solutions and advantages of the embodiments of the present invention clearer, the technical solutions in the embodiments of the present invention will be clearly and completely described below with reference to the drawings in the embodiments of the present invention. Obviously, the embodiments described are only part of the embodiments of the present invention, rather than all embodiments. Components of the embodiments of the present invention generally described and illustrated in the drawings herein may be arranged and designed in various different configurations.

Therefore, the following detailed description of the embodiments of the present invention provided in the drawings is not intended to limit the scope of the claimed present invention, but merely represents selected embodiments of the present invention. Based on the embodiments in the present invention, all other embodiments obtained by those ordinarily skilled in the art without creative efforts fall within the protection scope of the present invention.

It should be noted that similar reference numerals and letters represent similar items in the following drawings. Therefore, once an item is defined in a drawing, it does not need to be further defined and explained in subsequent drawings.

In the description of the present invention, it should be noted that an orientation or positional relationship indicated by the term such as "upper", "lower", "inner", "outer", is based on an orientation or positional relationship shown in the drawings, or an orientation or positional relationship in which the product of the present invention is customarily placed during use, which is only for the convenience of describing the present invention and simplifying the description, rather than indicating or implying that the referred device or element must have a specific orientation, be constructed and operated in a specific orientation, and thus cannot be understood as a limitation to the present invention.

In the description of the present invention, it should also be noted that unless otherwise clearly specified and limited, the terms such as "dispose" and "connect" should be interpreted broadly. For example, "connection" may be a fixed connection, a detachable connection, or an integral connection; may be a mechanical connection, or an electrical connection; may be a direct connection, or an indirect connection through an intermediate medium; may be an internal communication between two elements. For those of ordinary skill in the art, the specific meanings of the above terms in the present invention may be understood according to specific situations.

In the present invention, usually, a "front side" refers to a light-receiving surface after a cell is installed in place, and a "back side" refers to a opposite surface of the "front side". The "front side" refers to an upper surface of a cell shown in a figure, and the "back side" refers to a lower surface of the cell shown in the figure. Unless otherwise specified, the "front side" and the "back side" refer to two opposite surfaces of a layer structure. The phrase "from inside to outside" refers to a direction from an area proximate to a crystalline silicon layer to an area away from the crystalline silicon layer. The front side or the back side of the cell is divided into an electrode area and a non-electrode area. The electrode area refers to an area where grid line electrodes are arranged, and the non-electrode area refers to an area where no grid line electrodes are arranged.

In the prior art, the commonly used light conversion technology is to add a light conversion material as an additive into a paste, and then form a certain functional structure of a cell. This light conversion technology affects the function of the functional structure itself, and the improvement effect in light utilization rate is not obvious. For example, a light conversion material is added into a transparent conductive paste to be printed, sprayed or deposited on a surface of a silicon wafer, and then a transparent electrode is formed through high-temperature sintering or low-temperature curing. This technology not only affects the conductivity of the electrode, but also has little improvement in light utilization rate. In addition, an amorphous silicon layer in a heterojunction solar cell structure is prone to passivation attenuation under UV light irradiation, resulting in efficiency attenuation, i.e., a UVID phenomenon, which affects the long-term reliability of a module.

At present, there is a light conversion technology that is to improve a structure of a cell, but this light conversion technology is not easy to implement and has low feasibility. There is another light conversion technology that is to add a light conversion material as an additive into a paste, and then form a certain functional structure of a cell. This light conversion technology affects the function of the functional structure itself, and the improvement effect in light utilization rate is not obvious.

Therefore, there is an urgent need for a new light conversion material that is not only easy to process but also capable of effectively achieving down-conversion.

Due to numerous energy levels of rare earth ions, they can easily achieve multiple transitions for energy transfer, making them good light conversion materials. The inventors found that in order to achieve down-conversion in heterojunction solar cells, specific rare earth ion materials may be used as a separate layer structure and arranged in photovoltaic cells.

The purpose of the embodiments of the present invention is to provide a solar cell and a preparation method thereof. The solar cell of the present invention is capable of effectively converting UV light into visible light, so that on one hand, the utilization rate of the spectrum is significantly improved, and on another hand, the damage of UV light to the cell is reduced, thereby improving the conversion efficiency and reliability of the cell.

An embodiment of the present invention provides a solar cell. The solar cell includes a crystalline silicon layer. On a front side of the crystalline silicon layer, a first intrinsic layer, a first doped layer, a first transparent conductive film layer and a first metal electrode are sequentially stacked from inside to outside. On a back side of the crystalline silicon layer, a second intrinsic layer, a second doped layer, a second transparent conductive film layer and a second metal electrode are sequentially stacked from inside to outside. Light conversion layer(s) are further provided in the solar cell. The light conversion layer is located in at least one of following areas: an area on the first transparent conductive film layer where the first metal electrode is not disposed, an area on the second transparent conductive film layer where the second metal electrode is not disposed, an area between the first doped layer and the first transparent conductive film layer, and an area between the second doped layer and the second transparent conductive film layer. The light conversion layer contains an yttrium aluminum garnet-based quantum dot material.

It can be understood that the light conversion layer(s) containing the yttrium aluminum garnet (YAGT)-based quantum dot (QDs) material as light conversion particles are disposed on a front side and/or a back side of the first transparent conductive film layer and/or a front side and/or a back side of the second transparent conductive film layer in the cell. In a case where the light conversion layer is disposed on the front side of the first transparent conductive film layer or the back side of the second transparent conductive film layer, the light conversion layer is located in the non-electrode area avoiding an area of the first metal electrode or the second metal electrode. Therefore, the light conversion layer does not affect the conductivity of the electrode, and at the same time, the arrangement area of the light conversion layer is large, increasing an action area of the light conversion particles. Moreover, the yttrium aluminum garnet (YAGT)-based quantum dot (QDs) material as the light conversion particles has good emission saturation and strong stability, and are capable of effectively converting UV light into visible light, solving the problem of poor spectral response of solar cells (such as heterojunction solar cells) in the UV band, thereby broadening the spectral absorption range of the cell, improving the spectral response, enhancing the utilization rate and conversion efficiency of the spectrum, and having low cost.

Moreover, a light conversion layer is disposed on a front side and/or a back side of a solar cell (such as a heterojunction solar cell), and the light conversion layer converts UV light irradiated thereon into visible light, reducing the damage of UV light to the solar cell, especially to the crystalline silicon heterojunction solar cell, which alleviates the UVID problem of the cell, thereby improving the reliability of the cell module while improving the conversion efficiency of the cell.

In an optional embodiment, a surface of the crystalline silicon layer is a pyramid textured surface, and a thickness of the light conversion layer is 1/50 to 1/2 of a width of the pyramid textured surface. For example, the thickness of the light conversion layer is 1/45, 1/40, 1/35, 1/30, 1/25, 1/20, 1/15, 1/10, 1/9, 1/8, 1/7, 1/6, 1/5, 1/4, 1/3 or 1/2 of the width of the pyramid textured surface, or in a range composed of any two of these values, which is not limited here. In some embodiments, the thickness of the light conversion layer may be in a range of 1/45 to 1/5, 1/35 to 1/10, 1/30 to 1/15, 1/20 to 1/2, 1/10 to 1/5, etc. of the width of the pyramid textured surface.

In some optional embodiments, the width of the pyramid textured surface is in a range of 300 nm to 5 µm, and the thickness of the light conversion layer is in a range of 6 nm to 2.5 µm. In optional embodiments, the thickness of the light conversion layer may be, for example, 6 nm, 10 nm, 20 nm, 30 nm, 40 nm, 50 nm, 60 nm, 80 nm, 100 nm, 200 nm, 300 nm, 400 nm, 500 nm, 600 nm, 700 nm, 800 nm, 900 nm, 1 µm, 1.5 µm, 2 µm or 2.5 µm, or in a range defined by any two of the foregoing values. In some optional embodiments, the thickness of the light conversion layer may be in a range of, for example, 10 nm to 2 µm, 50 nm to 1.5 µm, 100 nm to 1 µm, 200 nm to 900 nm, 300 nm to 800 nm, 400 nm to 700 nm, etc.

In some optional embodiments, the yttrium aluminum garnet-based quantum dot material (yttrium aluminum garnet-based transparent fluorescent ceramic material) includes, but is not limited to, at least one of YAG:Ce³⁺, YAG:Pr³⁺, YAG:Cr³⁺ and other types of yttrium aluminum garnet-based transparent fluorescent ceramic materials.

In some optional embodiments, the light conversion layer further contains other light conversion particles, including but not limited to, nitride series quantum dot materials (such as β-SiAlON:Eu²⁺), silicate series quantum dot materials (such as CaAlSiN₃:Eu²⁺), fluoride series quantum dot materials (such as SrF₂:Eu²⁺), etc.

In some optional embodiments, the particle size of the yttrium aluminum garnet-based quantum dot material is in a range of 2 nm to 2 µm, optionally, in a range of 5 nm to 2 µm, 50 nm to 1 µm. For example, the particle size of the yttrium aluminum garnet-based quantum dot material is 5 nm, 10 nm, 20 nm, 40 nm, 50 nm, 70 nm, 100 nm, etc., or in a range defined by any two of the foregoing values, such as in a range of 2 nm to 100 nm, 2 nm to 50 nm or 2 nm to 20 nm, etc.

In some optional embodiments, the size of other light conversion particles is usually in a range of 5 nm to 2 µm, optionally, in a range of 5 nm to 2 µm, 50 nm to 1 µm. For example, the size of other light conversion particles is 5 nm, 10 nm, 20 nm, 40 nm, 50 nm, 70 nm or 100 nm, etc., or in a range defined by any two of the foregoing values, such as in a range of 2 nm to 100 nm, 2 nm to 50 nm or 2 nm to 20 nm, etc.

It can be understood that the light conversion layer containing the specific light conversion particles such as the yttrium aluminum garnet-based quantum dot material covers a pyramid area without electrodes on the front side of the cell. If the size of the light conversion particles is too large, it causes the light conversion particles to be stuck between two pyramids, so that the light conversion particles have poor adhesion, and the light trapping effect of the pyramids is also weakened.

In the above embodiments, the particle size of the specific light conversion particles such as the yttrium aluminum garnet-based quantum dot material is adjusted within a certain nanoscale range. If the size of the light conversion particles is too small, the processing cost is expensive; if the size of the light conversion particles is too large, they are not easy to adhere to the surface of the cell.

In some optional embodiments, the light conversion layer further contains a polymer matrix, and the yttrium aluminum garnet-based quantum dot material is dispersed in the polymer matrix.

In the above embodiments, the polymer matrix makes the specific light conversion particles such as the yttrium aluminum garnet-based quantum dot material adhere to the surface of the cell, and keeps the light conversion particles uniformly dispersed, thereby converting UV light into visible light without affecting light absorption.

In some optional embodiments, a content of the yttrium aluminum garnet-based quantum dot material in the light conversion layer is in a range of 40 wt% to 60 wt%, such as 40 wt%, 42 wt%, 44 wt%, 46 wt%, 48 wt%, 50 wt%, 52 wt%, 54 wt%, 56 wt%, 58 wt% or 60 wt%, etc., or in a range defined by any two of the foregoing values, such as in a range of 40 wt% to 60 wt%, 42 wt% to 58 wt%, 44 wt% to 56 wt%, 46 wt% to 54 wt%, 48 wt% to 52 wt%, etc.

In some optional embodiments, a content of other light conversion particles in the light conversion particles does not exceed 10 wt%, and a content of the yttrium aluminum garnet-based quantum dot material in the light conversion particles is in a range of 90 wt% to 100 wt%, such as 90 wt%, 91 wt%, 92 wt%, 93 wt%, 94 wt%, 95 wt%, 96 wt%, 97 wt%, 98 wt%, 99 wt% or 100 wt%, etc., or in a range defined by any two of the foregoing values, such as in a range of 40 wt% to 60 wt%, 92 wt% to 98 wt% or 94 wt% to 96 wt%, etc.

In the above embodiments, the content of the specific light conversion particles such as yttrium aluminum garnet-based quantum dot material in the light conversion layer is adjusted within a certain range to achieve better light conversion efficiency. If the content of the yttrium aluminum garnet-based quantum dot material is too low, the light conversion efficiency of the light conversion layer is low; if the content of the yttrium aluminum garnet-based quantum dot material is too high, the reflection of the light conversion layer is too high, thereby affecting the absorption of other light.

An embodiment of the present invention provides a preparation method of the solar cell provided in the first aspect. The preparation method includes following steps.

The first intrinsic layer, the first doped layer, and the first transparent conductive film layer that are sequentially stacked are formed on the front side of the crystalline silicon layer. The first metal electrode is formed on the front side of the first transparent conductive film layer. The second intrinsic layer, the second doped layer, the second transparent conductive film layer, and the second metal electrode that are sequentially stacked are formed on the back side of the crystalline silicon layer. The light conversion layer is disposed in at least one of the following areas: the area on the first transparent conductive film layer where the first metal electrode is not disposed, the area on the second transparent conductive film layer where the second metal electrode is not disposed, the area between the first doped layer and the first transparent conductive film layer, and the area between the second doped layer and the second transparent conductive film layer.

In the above embodiment, the first metal electrode and the light conversion layer are respectively formed on the front side of the cell, so that the process is simple and the cost is low.

In some optional embodiments, the light conversion layer is formed by printing and curing a light conversion paste, and the light conversion paste includes the yttrium aluminum garnet-based quantum dot material, a polymer additive, and an organic solvent.

In the above embodiments, the yttrium aluminum garnet (YAGT)-based quantum dot (QDs) material is directly coated as the light conversion particles by a simple printing method, so that the process is simple.

In some optional embodiments, a mass ratio of the yttrium aluminum garnet-based quantum dot material, the polymer additive, and the organic solvent in the light conversion paste is (0.01-0.7): (0.01-0.7): 1.

In the above embodiments, if the proportion of the polymer additive in the light conversion paste is too small, the solution is too dilute and easy to spread to other areas after printing, resulting in poor contact of subsequently formed grid line electrodes; if the proportion of the polymer additive in the light conversion paste is too large, the solution is too sticky and not easy to print.

In order to further improve the output power of photovoltaic cells and modules, the light conversion technology has become an effective method. The so-called light conversion technology is to convert light that cannot be utilized by the cell into light that can be utilized by the cell. Due to the optical properties of silicon materials, they can only absorb most of visible light and a small part of ultraviolet and infrared light. Therefore, the light conversion technology can be divided into up-conversion and down-conversion. The up-conversion is to convert low-energy infrared light into medium-energy visible light, and the down-conversion is to convert high-energy ultraviolet light into medium-energy visible light.

In addition, a heterojunction solar cell has poor spectral response in the UV band, and an amorphous silicon passivation layer therein is prone to passivation attenuation under UV light irradiation, resulting in efficiency attenuation, i.e., a UVID phenomenon, which affects the long-term reliability of a module.

Therefore, firstly, the down-conversion is performed on the heterojunction solar cell. That is, high-energy ultraviolet light is converted into medium-energy visible light.

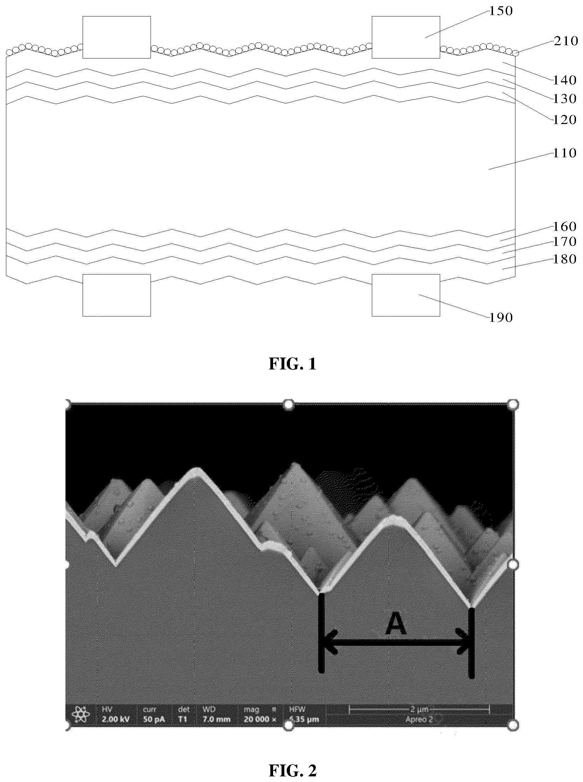

Referring to FIG. 1, the solar cell provided in the embodiment of the present invention includes the crystalline silicon layer 110. On the front side of the crystalline silicon layer 110, the first intrinsic layer 120, the first doped layer 130, the first transparent conductive film layer 140, and the first metal electrode 150 are sequentially stacked from inside to outside. A first light conversion layer 210 is further provided in an area on the front side of the first transparent conductive film layer 140 where the first metal electrode 150 is not disposed. On the back side of the crystalline silicon layer 110, the second intrinsic layer 160, the second doped layer 170, the second transparent conductive film layer 180, and the second metal electrode 190 are sequentially stacked from inside to outside.

In the embodiments of the present invention, the crystalline silicon layer 110 may be of N-type crystalline silicon or P-type crystalline silicon, which may be single crystal or quasi-single crystal, with a thickness in a range of 50 µm to 250 µm, such as 50 µm, 100 µm, 150 µm, 200 µm, or 250 µm, or any intermediate value between any two of the foregoing values.

Referring to FIG. 2, the surface (the front side and the back side) of the crystalline silicon layer 110 is the pyramid textured surface. The width of the pyramid textured surface refers to an average length of base edges of a pyramid structure, which is a length A marked by an arrow in the figure. The width of the pyramid textured surface may be in a range of 300 nm to 5 µm, such as 300 nm, 500 nm, 1 µm, 1.5 µm, 2 µm, 3 µm, 4 µm, or 5 µm, or any intermediate value between any two of the foregoing values.

In the embodiments of the present invention, the first intrinsic layer 120 and the second intrinsic layer 160 may each be an amorphous silicon film, optionally, a composite film layer formed by one or a combination of more than one of undoped amorphous silicon, amorphous silicon oxide, and amorphous silicon carbide semiconductor films, with a thickness in a range of 3 nm to 10 nm, such as 3 nm, 4 nm, 6 nm, 8 nm, 10 nm, or any intermediate value between any two of the foregoing values. The first intrinsic layer 120 and the second intrinsic layer 160 may be prepared by plasma enhanced chemical vapor deposition (PECVD) or catalytic chemical vapor deposition (Cat-CVD).

In the embodiments of the present invention, the first doped layer 130 and the second doped layer 170 may each be a composite film layer formed by one or a combination of more than one of doped amorphous silicon, microcrystalline silicon, nanocrystalline silicon, amorphous silicon carbide, microcrystalline silicon carbide, nanocrystalline silicon carbide, amorphous silicon oxide, microcrystalline silicon oxide, and nanocrystalline silicon oxide. That is, the first doped layer 130 and the second doped layer 170 may each be of a single-layer or multi-layer structure. The first doped layer 130 and the second doped layer 170 may each be an N-type doped layer or a P-type doped layer. In a case where the first doped layer 130 on the front side is an N-type doped layer, the second doped layer 170 on the back side is a P-type doped layer. In a case where the first doped layer 130 on the front side is a P-type doped layer, the second doped layer 170 on the back side is an N-type doped layer. A thickness of the first doped layer 130 and a thickness of the second doped layer 170 may each be in a range of 10 nm to 30 nm, such as 10 nm, 15 nm, 18 nm, 20 nm, 25 nm, or 30 nm, or any intermediate value between any two of the foregoing values. The first doped layer 130 and the second doped layer 170 may be prepared by PECVD or Cat-CVD.

In the embodiments of the present invention, materials of the first transparent conductive film layer 140 and the second transparent conductive film layer 180 may each include a composite layer formed by one or a combination of more than one selected from doped In₂O₃, doped ZnO, and doped SnO₂, with a thickness in a range of 50 nm to 100 nm, such as 50 nm, 70 nm, 80 nm, 90 nm, or 100 nm, or any intermediate value between any two of the foregoing values. The first transparent conductive film layer 140 and the second transparent conductive film layer 180 may be prepared by physical vapor deposition (PVD) or reactive plasma deposition (RPD).

In the embodiments of the present invention, the first metal electrode 150 and the second metal electrode 190 may each be a low-temperature metal paste electrode composed of one or a combination of more than one of Ag, Cu, Al, and Ni, with a thickness in a range of 10 µm to 50 µm and a width in a range of 5 µm to 50 µm. The first metal electrode 150 and the second metal electrode 190 may be prepared by screen printing, inkjet printing, or laser transfer.

In the embodiments of the present invention, the first light conversion layer 210 contains light conversion particles, and the light conversion particles include the yttrium aluminum garnet-based quantum dot material (yttrium aluminum garnet-based transparent fluorescent ceramic material). The yttrium aluminum garnet-based quantum dot material includes, but is not limited to, at least one of YAG:Ce³⁺, YAG:Pr³⁺, YAG:Cr³⁺, and other types of yttrium aluminum garnet-based transparent fluorescent ceramic materials. The light conversion particles may further include a small amount of nitride series quantum dot materials (such as β-SiAlON:Eu²⁺), silicate series quantum dot materials (such as CaAlSiN₃:Eu²⁺), fluoride series quantum dot materials (such as SrF₂:Eu²⁺), etc.

A thickness of the first light conversion layer 210 is in a range of 1/50 to 1/2 of the width of the pyramid textured surface. The thickness of the first light conversion layer 210 may be in a range of 6 nm to 2.5 µm.

In the embodiments of the present invention, the first light conversion layer 210 further contains a polymer matrix, and the light conversion particles are dispersed in the polymer matrix. A content of the yttrium aluminum garnet-based quantum dot material in the first light conversion layer 210 is in a range of 40 wt% to 60 wt%, such as 40 wt%, 50 wt%, 60 wt%, or any intermediate value between any two of the foregoing values. The content of the yttrium aluminum garnet-based quantum dot material in the light conversion particles is in a range of 90 wt% to 100 wt%.

The embodiment of the present invention provides the preparation method of the above heterojunction solar cell. The preparation method includes following steps. The first intrinsic layer 120, the first doped layer 130, and the first transparent conductive film layer 140 that are sequentially stacked are formed on the front side of the crystalline silicon layer 110. The first metal electrode 150 and the first light conversion layer 210 are respectively formed in different areas on the front side of the first transparent conductive film layer 140. The second intrinsic layer 160, the second doped layer 170, the second transparent conductive film layer 180, and the second metal electrode 190 that are sequentially stacked are formed on the back side of the crystalline silicon layer 110.

As an embodiment, the preparation method of the heterojunction solar cell includes following steps.
(1) A silicon wafer is selected, and texturing and cleaning are performed on the silicon wafer to obtain the crystalline silicon layer 110 with the pyramid textured surface. An N-type monocrystalline silicon wafer is selected, and a cleaning machine is used to perform texturing and cleaning on the N-type monocrystalline silicon wafer, so as to obtain the crystalline silicon layer 110 with the textured surface.
(2) The first intrinsic layer 120 and the second intrinsic layer 160 are prepared respectively on the front side and the back side of the crystalline silicon layer 110. PECVD is used to prepare double-sided intrinsic amorphous silicon film layers respectively on the front side and the back side of the crystalline silicon wafer, so as to obtain the first intrinsic layer 120 and the second intrinsic layer 160.
(3) The first doped layer 130 is prepared on a front side of the first intrinsic layer 120, and the second doped layer 170 is prepared on a front side of the second intrinsic layer 160. In this embodiment, PECVD is used to plate the first doped layer 130 on the first intrinsic layer 120 and plate the second doped layer 170 on the second intrinsic layer 160.
(4) The first transparent conductive film layer 140 is prepared on a front side of the first doped layer 130, and the second transparent conductive film layer 180 is prepared on a front side of the second doped layer 170. In this embodiment, a PVD coating device is used to prepare the first transparent conductive film layer 140 and the second transparent conductive film layer 180.
(5) The first light conversion layer 210 and the first metal electrode 150 are respectively prepared on a front side of the first transparent conductive film layer 140, and the second metal electrode 190 is prepared on a front side of the second transparent conductive film layer 180.

Exemplarily, the first light conversion layer 210 is formed by printing and curing the light conversion paste. Tools used for printing include, but are not limited to, a stainless steel screen, a conventional emulsion screen, and a PI screen. By adjusting printing parameter(s), the problem of poor printability is solved, and the best printability is achieved. The light conversion paste includes the light conversion particles of the yttrium aluminum garnet-based quantum dot material, the polymer additive, and the organic solvent. The mass ratio of the yttrium aluminum garnet-based quantum dot material, the polymer additive, and the organic solvent in the light conversion particles of the light conversion paste may be (0.01-0.7): (0.01-0.7): 1. The organic solvent includes, but is not limited to, at least one of alcohol organic solvents such as ethanol, propanol, terpineol, and butyl carbitol. The polymer additive includes, but is not limited to, at least one of polymer materials such as ethyl cellulose and polyethylene-polyvinyl acetate copolymer. Before printing, it is necessary to prepare the light conversion paste containing the yttrium aluminum garnet-based transparent fluorescent ceramic material. Firstly, the ground yttrium aluminum garnet-based transparent fluorescent ceramic material nanoparticles are added into the organic solvent, then the polymer additive is added, and a fully stir is performed to form the light conversion paste. The organic solvent is capable of dissolving the polymer additive therein and dispersing the light conversion particles therein, and then the polymer matrix with the light conversion particles dispersed inside is formed through printing and curing.

The first metal electrode 150 and the second metal electrode 190 may also be formed by printing.

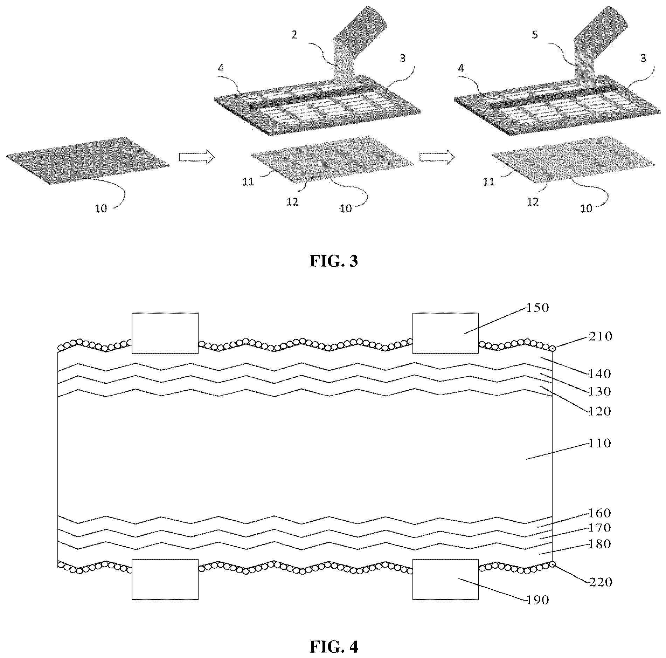

Referring to FIG. 3, the light conversion paste 2 containing the yttrium aluminum garnet-based transparent fluorescent ceramic material is filled into a patterned screen 3. The light conversion paste 2 is printed on the non-electrode area 11 on the front side of the first transparent conductive film layer 140 in the cell 10 to be printed obtained in step (4) using a printing device equipped with a scraper 4, and is dried and cured at a temperature below 200°C for 2 min to 10 min to form the first light conversion layer 210.

Then, a metal paste 5 is printed on the electrode area 12 of the first transparent conductive film layer 140 in the same manner as above. A furnace device is used to dry and cure the surface of the cell to form the first metal electrode 150. The metal paste 5 is printed on the electrode area 12 of the second transparent conductive film layer 180, and is dried and cured to form the second metal electrode 190, so as to finally obtain the cell. The metal paste 5 may be one or more of low-temperature silver paste and low-temperature silver-copper paste. In some embodiments, the first metal electrode 150 and the second metal electrode 190 may also be formed by electroplating, and the material of the metal electrode may be one or more of copper, aluminum, silver, and other materials.

In the above process, the pattern of the screen 3 for printing the light conversion paste 2 is opposite to that of the screen for printing the metal paste 5 to ensure that the light conversion paste 2 is printed in a specific area and the metal paste 5 is printed in another specific area.

In other embodiments, the light conversion layer may further be disposed in the non-electrode area on the back side of the first transparent conductive film layer 140, or the area between the first doped layer 130 and the first transparent conductive film layer 140, or the area between the second doped layer 170 and the second transparent conductive film layer 180, and the corresponding preparation method is adjusted accordingly.

### Example 1

The solar cell includes the crystalline silicon layer 110. On the front side of the crystalline silicon layer 110, the first intrinsic layer 120, the first doped layer 130, the first transparent conductive film layer 140, and the first metal electrode 150 are sequentially stacked from inside to outside. The first light conversion layer 210 is further disposed in the area on the front side of the first transparent conductive film layer 140 where the first metal electrode 150 is not disposed. On the back side of the crystalline silicon layer 110, the second intrinsic layer 160, the second doped layer 170, the second transparent conductive film layer 180, and the second metal electrode 190 are sequentially stacked from inside to outside.

The crystalline silicon layer 110 is an N-type monocrystalline silicon wafer with a thickness of 150 µm, and the width of the pyramid textured surface is 2 µm.

Both the first intrinsic layer 120 and the second intrinsic layer 160 are intrinsic amorphous silicon film layers with a thickness of 7 nm.

The first doped layer 130 is an N-type doped amorphous silicon layer with a thickness of 15 nm, and the second doped layer 170 is a P-type doped amorphous silicon layer with a thickness of 15 nm.

The materials of the first transparent conductive film layer 140 and the second transparent conductive film layer 180 are both ITO, in which a mass percentage of In₂O₃ is 97% and a mass percentage of SnO₂ is 3%, with a thickness of 80 nm.

The first metal electrode 150 and the second metal electrode 190 are silver paste electrodes with a thickness of 30 µm and a width of 10 µm.

The thickness of the first light conversion layer 210 is 500 nm. In the first light conversion layer 210, the content of the light conversion particles is 50 wt%, and the content of the polymer matrix is 50 wt%. The content of the yttrium aluminum garnet-based quantum dot material (YAG:Ce³⁺) in the light conversion particles is 100 wt%. The size of the yttrium aluminum garnet-based quantum dot material is 200 nm.

The preparation method is as follows.
(1) A silicon wafer is selected, and texturing and cleaning are performed on the silicon wafer to obtain the crystalline silicon layer 110 with the pyramid textured surface. An N-type monocrystalline silicon wafer is selected, and a cleaning machine is used to perform texturing and cleaning on the N-type monocrystalline silicon wafer, so as to obtain the crystalline silicon layer 110 with the textured surface.
(2) The first intrinsic layer 120 and the second intrinsic layer 160 are prepared respectively on the front side and the back side of the crystalline silicon layer 110. PECVD is used to prepare double-sided intrinsic amorphous silicon film layers respectively on the front side and the back side of the crystalline silicon wafer, so as to obtain the first intrinsic layer 120 and the second intrinsic layer 160.
(3) The first doped layer 130 is prepared on the front side of the first intrinsic layer 120, and the second doped layer 170 is prepared on the front side of the second intrinsic layer 160. In this embodiment, PECVD is used to plate the first doped layer 130 on the first intrinsic layer 120 and plate the second doped layer 170 on the second intrinsic layer 160.
(4) The first transparent conductive film layer 140 is prepared on the front side of the first doped layer 130, and the second transparent conductive film layer 180 is prepared on the front side of the second doped layer 170. In this embodiment, the PVD coating device is used to prepare the first transparent conductive film layer 140 and the second transparent conductive film layer 180.
(5) The first light conversion layer 210 and the first metal electrode 150 are respectively prepared on the front side of the first transparent conductive film layer 140, and the second metal electrode 190 is prepared on the front side of the second transparent conductive film layer 180.

The first metal electrode 150 and the second metal electrode 190 may also be formed by printing.

Specifically, the light conversion paste 2 containing the yttrium aluminum garnet-based transparent fluorescent ceramic material is filled into the patterned screen 3. The light conversion paste 2 is printed on the non-electrode area 11 on the front side of the first transparent conductive film layer 140 in the cell 10 to be printed obtained in step (4) using the printing device equipped with the scraper 4, and is dried and cured at a temperature below 200°C for 2 min to 10 min to form the first light conversion layer 210.

Then, the metal paste 5 is printed on the electrode area 12 of the first transparent conductive film layer 140 in the same manner as above. The furnace device is used to dry and cure the surface of the cell to form the first metal electrode 150. The metal paste 5 is printed on the electrode area 12 of the second transparent conductive film layer 180, and is dried and cured to form the second metal electrode 190, so as to finally obtain the cell.

### Example 2

Referring to FIG. 4, a solar cell provided in this example is a double-sided cell, which differs from Example 1 in that: a second light conversion layer 220 is further provided in the area on the back side of the second transparent conductive film layer 180 where the second metal electrode 190 is not disposed. A material and a thickness of the second light conversion layer 220 are respectively the same as the material and the thickness of the first light conversion layer 210.

### Example 3

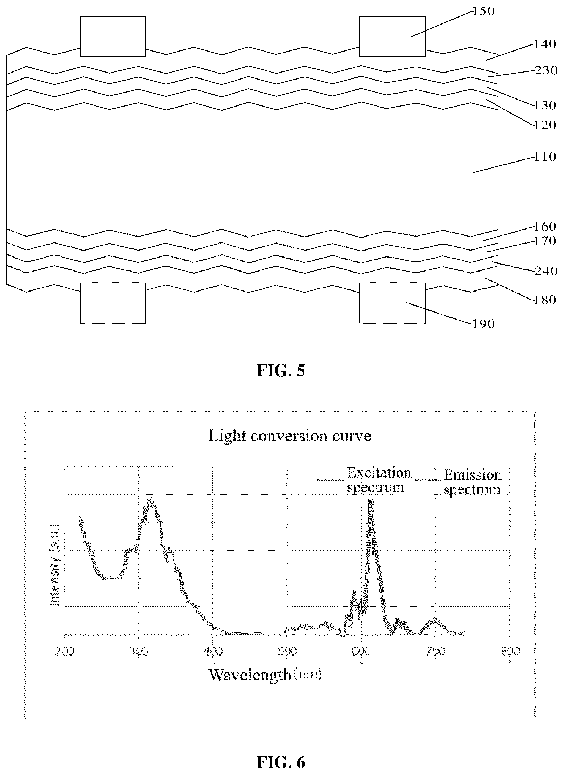

Referring to FIG. 5, a solar cell provided in this example is a double-sided cell, which differs from Example 1 in that: the first light conversion layer 210 is not disposed, but a third light conversion layer 230 is disposed between the first doped layer 130 and the first transparent conductive film layer 140, and a fourth light conversion layer 240 is disposed between the second doped layer 170 and the second transparent conductive film layer 180. Materials of the third light conversion layer 230 and the fourth light conversion layer 240 are the same as the material of the first light conversion layer 210, and thicknesses of both the third light conversion layer 230 and the fourth light conversion layer 240 are 1 µm.

### Comparative Example 1

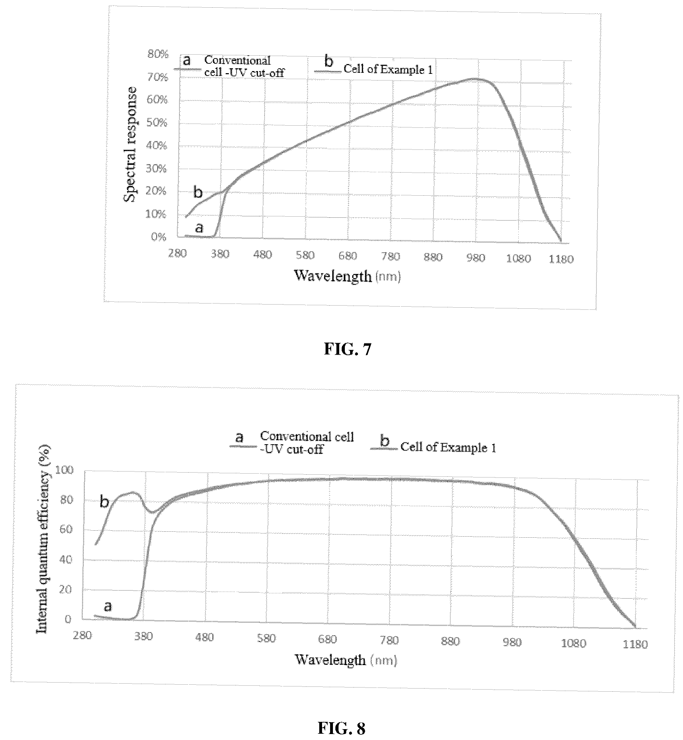

This comparative example provides a solar cell, which differs from Example 1 in that: the solar cell is a conventional cell without a light conversion layer.
I. A light conversion test was conducted on the light conversion layer in Example 1. Specifically, the light conversion layer was peeled off and placed on a transparent glass material, and analyzed and tested using a fluorescence spectrometer. The analysis and test results are shown in FIG. 6.
   The picture on the left in FIG. 6 is an excitation spectrum of the light conversion layer, and the picture on the right is an emission spectrum of the light conversion layer. It can be seen from FIG. 6 that the light conversion layer formed in the present invention has the functions of ultraviolet light excitation and visible light emission, i.e., is capable of effectively converting ultraviolet light into visible light.
II. Spectral response tests were conducted on the cells in Example 1 and Comparative Example 1 under the same conditions. The spectral response was conducted using a quantum efficiency testing instrument. The finished cell was placed on a fixed metal table, and a metal probe was used to contact an upper electrode. Under light irradiation, the cell generates a current signal, which is collected by a collector, and a conversion relationship between the current signal and the light signal, i.e., the spectral response curve, is output. The comparison results of the spectral response curves of Example 1 and Comparative Example 1 obtained from the tests are shown in FIG. 7, and the comparison results of internal quantum efficiency curves of Example 1 and Comparative Example 1 are shown in FIG. 8. In FIGS. 7 and 8, curve a represents the conventional cell of Comparative Example 1, and curve b represents the cell of Example 1.

It can be seen from FIGS. 7 and 8 that adding the light conversion layer in the non-electrode area on the front side of the solar cell in the present invention is capable of improving the response of the cell to ultraviolet light without affecting the response of the cell to other spectra, thereby significantly improving the conversion effect of the cell.

In summary, the solar cell and the preparation method thereof are provided in the embodiments of the present invention. The cell is capable of effectively converting UV light into visible light, so that on one hand, the utilization rate of the spectrum is significantly improved, and on another hand, the damage of UV light to the cell is reduced, thereby improving the conversion efficiency and the reliability of the cell.

The above are only the embodiments of the present invention, and are not intended to limit the protection scope of the present invention. For those skilled in the art, various changes and variations may be made to the present invention. Any changes, equivalent replacements, improvements, etc. made within the spirit and principles of the present invention should be included in the protection scope of the present invention.

### INDUSTRIAL PRACTICALITY

The present invention provides a solar cell and a preparation method thereof, relating to the field of solar cells. The solar cell includes the crystalline silicon layer. On the front side of the crystalline silicon layer, the first intrinsic layer, the first doped layer, the first transparent conductive film layer, and the first metal electrode are sequentially stacked from inside to outside. On the back side of the crystalline silicon layer, the second intrinsic layer, the second doped layer, the second transparent conductive film layer, and the second metal electrode are sequentially stacked from inside to outside. The light conversion layer(s) are disposed on the front side and/or the back side of the first transparent conductive film layer and/or the front side and/or the back side of the second transparent conductive film layer, and the light conversion layer contains the yttrium aluminum garnet-based quantum dot material. The solar cell in the embodiments of the present invention is capable of effectively converting UV light into visible light, so that on one hand, the utilization rate of the spectrum is significantly improved, and on another hand, the damage of UV light to the cell is reduced, thereby improving the conversion efficiency and the reliability of the cell and having excellent industrial practicability.

## Claims

1. A solar cell, **characterized by** comprising a crystalline silicon layer, wherein a first intrinsic layer, a first doped layer, a first transparent conductive film layer, and a first metal electrode are sequentially stacked from inside to outside on a front side of the crystalline silicon layer; and a second intrinsic layer, a second doped layer, a second transparent conductive film layer, and a second metal electrode are sequentially stacked from inside to outside on a back side of the crystalline silicon layer, wherein at least one light conversion layer is further provided in the solar cell, and the light conversion layer is located in at least one of following areas: an area on the first transparent conductive film layer where the first metal electrode is not disposed, an area on the second transparent conductive film layer where the second metal electrode is not disposed, an area between the first doped layer and the first transparent conductive film layer, and an area between the second doped layer and the second transparent conductive film layer; and the light conversion layer contains an yttrium aluminum garnet-based quantum dot material.

2. The solar cell according to claim 1, wherein one or two light conversion layers are provided;
optionally, two light conversion layers are provided, and are disposed respectively on the front side and the back side of the crystalline silicon layer.

3. The solar cell according to claim 1 or 2, wherein the light conversion layer comprises light conversion particles, and the light conversion particles comprise the yttrium aluminum garnet-based quantum dot material.

4. The solar cell according to any one of claims 1 to 3, wherein a surface of the crystalline silicon layer is a pyramid textured surface, and a thickness of the light conversion layer is in a range of 1/50 to 1/2 of a width of the pyramid textured surface.

5. The solar cell according to claim 4, wherein the width of the pyramid textured surface is in a range of 300 nm to 5 µm, and the thickness of the light conversion layer is in a range of 6 nm to 2.5 µm.

6. The solar cell according to any one of claims 1 to 5, wherein the yttrium aluminum garnet-based quantum dot material comprises at least one selected from YAG:Ce³⁺, YAG:Pr³⁺, and YAG:Cr³⁺.

7. The solar cell according to any one of claims 1 to 6, wherein a size of the yttrium aluminum garnet-based quantum dot material is in a range of 5 nm to 2 µm;
optionally, the size of the yttrium aluminum garnet-based quantum dot material is in a range of 2 nm to 100 nm, optionally, in a range of 2 nm to 50 nm, optionally, in a range of 2 nm to 20 nm.

8. The solar cell according to any one of claims 1 to 7, wherein the light conversion layer further comprises other light conversion particles;
optionally, the other light conversion particles are selected from nitride series quantum dot materials, silicate series quantum dot materials, or fluoride series quantum dot materials;
optionally, a content of the other light conversion particles in the light conversion particles does not exceed 10 wt%.

9. The solar cell according to any one of claims 1 to 8, wherein a content of the yttrium aluminum garnet-based quantum dot material in the light conversion layer is in a range of 40 wt% to 60 wt%.

10. The solar cell according to any one of claims 1 to 9, wherein the light conversion layer further contains a polymer matrix, and the light conversion particles are dispersed in the polymer matrix;
optionally, the light conversion layer further contains the polymer matrix, and the yttrium aluminum garnet-based quantum dot material is dispersed in the polymer matrix;
optionally, the polymer matrix is prepared from a polymer material and an organic solvent.

11. A preparation method of the solar cell according to any one of claims 1 to 10, **characterized by** comprising following steps:
forming the first intrinsic layer, the first doped layer, and the first transparent conductive film layer that are sequentially stacked on the front side of the crystalline silicon layer; forming the first metal electrode on a front side of the first transparent conductive film layer; forming the second intrinsic layer, the second doped layer, the second transparent conductive film layer, and the second metal electrode that are sequentially stacked on the back side of the crystalline silicon layer; and providing the light conversion layer in at least one of the following areas: the area on the first transparent conductive film layer where the first metal electrode is not disposed, the area on the second transparent conductive film layer where the second metal electrode is not disposed, the area between the first doped layer and the first transparent conductive film layer, and the area between the second doped layer and the second transparent conductive film layer.

12. The preparation method of the solar cell according to claim 11, wherein the light conversion layer is formed by printing and curing a light conversion paste;
optionally, the light conversion paste comprises light conversion particles, a polymer material, and an organic solvent;
optionally, the light conversion particles contain the yttrium aluminum garnet-based quantum dot material.

13. The preparation method of the solar cell according to claim 11, wherein the light conversion layer is formed by printing and curing a light conversion paste, and the light conversion paste comprises the yttrium aluminum garnet-based quantum dot material, a polymer additive, and an organic solvent.

14. The preparation method of the solar cell according to any one of claims 11 to 13, wherein a mass ratio of the light conversion particles, the polymer additive, and the organic solvent in the light conversion paste is (0.01-0.7): (0.01-0.7): 1;
optionally, the light conversion particles contain the yttrium aluminum garnet-based quantum dot material;
optionally, a mass ratio of the yttrium aluminum garnet-based quantum dot material, the polymer additive, and the organic solvent in the light conversion paste is (0.01-0.7): (0.01-0.7): 1.

15. A solar cell, **characterized by** comprising a light conversion layer, wherein the light conversion layer contains light conversion particles, and the light conversion particles comprise an yttrium aluminum garnet-based quantum dot material;
optionally, in the light conversion layer, a content of the yttrium aluminum garnet-based quantum dot material is in a range of 40 wt% to 60 wt%.
